# EUROPEAN PATENT APPLICATION

(11) **EP 4 503 872 A1**
(43) Date of publication of application: **05.02.2025**
(21) Application number: 23780830.8
(22) Date of filing: 30.03.2023
(51) Int. Cl.: H05K 3/42, H05K 3/46

(54) **CIRCUIT BOARD**

(30) Priority: 30.03.2022 JP 2022056483
(71) Applicant: Kyocera Corporation, Kyoto-shi, Kyoto 612-8501 (JP)
(72) Inventor: SHIMIZU, Daichi, Kyoto-shi, Kyoto 612-8501 (JP)
(74) Representative: Viering, Jentschura & Partner mbB Patent- und Rechtsanwälte
(86) International application number: PCT/JP2023/013074
(87) International publication number: WO 2023/190822

(57) **Abstract**

A wiring board according to an embodiment of the present disclosure includes an insulating layer including a first surface and a second surface opposite to the first surface, a through hole having openings in the first surface and the second surface of the insulating layer, a through-hole electrical conductor located from a periphery of the opening in the first surface to a periphery of the opening in the second surface via an inner wall surface of the through hole, and a filling resin located in a region surrounded by the through-hole electrical conductor and including two surfaces that are a first surface on the first surface side and a second surface on the second surface side. The through-hole electrical conductor includes a first through-hole electrical conductor. The first through-hole electrical conductor includes a protruding portion extending to an inside of the through hole in at least one opening of the through hole. In a cross-sectional view, an angle formed between a portion of the protruding portion adjacent to the filling resin and at least the first surface or the second surface of the filling resin is an obtuse angle.

## Description

### TECHNICAL FIELD

The present invention relates to a wiring board.

### BACKGROUND OF INVENTION

In a wiring board of the related art, there is a case where a through-hole electrical conductor is filled in a through hole and there is a case where a through-hole electrical conductor is formed only on an inner wall surface of a through hole and a remaining portion in the through hole is filled with a resin. For example, in a wiring board described in Patent Document 1, an electrical conductor film is located on an inner wall surface of a through hole, and a filler formed of resin is located in a remaining portion in the through hole.

When the electrical conductor film is located on the inner wall surface of the through hole and the filler formed of a resin is located in the remaining portion as in the wiring board described in Patent Document 1, for example, under high-temperature conditions, the filler formed of a resin expands, and stress is concentrated at a corner portion of the through hole. When the stress is concentrated as such, a crack occurs in the through-hole electrical conductor or a through hole land is peeled off. As a result, the electrical reliability of the wiring board becomes poor.

### CITATION LIST

### PATENT LITERATURE

Patent Document 1: JP 2021-27167 A

### SUMMARY

### SOLUTION TO PROBLEM

A wiring board according to an embodiment of the present disclosure includes an insulating layer including a first surface and a second surface opposite the first surface, a through hole having openings in the first surface and the second surface of the insulating layer, a through-hole electrical conductor located from a periphery of the opening in the first surface to a periphery of the opening in the second surface via an inner wall surface of the through hole, and a filling resin located in a region surrounded by the through-hole electrical conductor and including two surfaces that are a first surface on the first surface side and a second surface on the second surface side. The through-hole electrical conductor includes a first through-hole electrical conductor. The first through-hole electrical conductor includes a protruding portion extending to an inside of the through hole in at least one opening of the through hole. In a cross-sectional view, an angle formed between a portion of the protruding portion adjacent to the filling resin and at least the first surface or the second surface of the filling resin is an obtuse angle.

### BRIEF DESCRIPTION OF THE DRAWINGS

FIG. 1 is a cross-sectional view illustrating a wiring board according to an embodiment of the present disclosure.
FIG. 2 is an enlarged illustration view for illustrating a region X illustrated in FIG. 1.
FIG. 3 is an enlarged illustration view for illustrating a region Y illustrated in FIG. 1.
FIG. 4 is an illustration view for illustrating a process for forming the region X illustrated in FIG. 1.
FIG. 5 is an illustration view for illustrating the process for forming the region X illustrated in FIG. 1.

### DESCRIPTION OF EMBODIMENTS

In the wiring board of the related art as described in Patent Document 1, when the electrical conductor film is located on the inner wall surface of the through hole and the filler formed of resin is located in the remaining portion, for example, under high-temperature conditions, the filler formed of a resin expands, and stress is concentrated at the corner portion of the through hole. When the stress is concentrated as such, a crack occurs in the through-hole electrical conductor or a through-hole land is peeled off. As a result, the electrical reliability of the wiring board becomes poor. Therefore, there is a demand for a wiring board in which cracks occurring in a through-hole electrical conductor are reduced and which has excellent electrical reliability.

A wiring board according to an embodiment of the present disclosure has a configuration as described in the section of Summary of the Invention, so that cracks occurring in the through-hole electrical conductor are reduced and excellent electrical reliability is ensured.

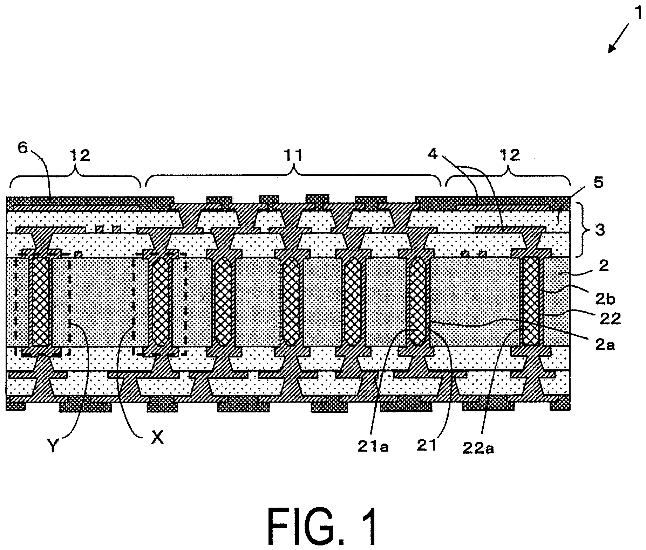

The wiring board according to an embodiment of the present disclosure will be described with reference to FIGs. 1 to 3. FIG. 1 is a cross-sectional view illustrating a wiring board 1 according to an embodiment of the present disclosure. The wiring board 1 according to a first embodiment includes a core insulating layer 2, a build-up layer 3, and a solder resist 6.

The core insulating layer 2 is not particularly limited as long as it is formed of a material having an insulating property. Examples of the material having the insulating property include resins such as an epoxy resin, a bismaleimide-triazine resin, a polyimide resin, and a polyphenylene ether resin. Two or more types of these resins may be mixed and used. The thickness of the core insulating layer 2 is not particularly limited and is, for example, 800 µm or greater and 1400 µm or less.

The core insulating layer 2 may include a reinforcing material. Examples of the reinforcing material include insulating fabric materials such as glass fiber, glass non-woven fabric, aramid non-woven fabric, aramid fiber, and polyester fiber. Two or more types of reinforcing materials may be used in combination. An inorganic insulating filler such as silica, barium sulfate, talc, clay, glass, calcium carbonate, or titanium oxide may be dispersed in the core insulating layer 2. Two or more types of inorganic insulating fillers may be used in combination.

The build-up layer 3 is located on each of a first surface and a second surface of the core insulating layer 2. The first surface and the second surface refer to an upper surface and a lower surface. In FIG. 1, for convenience, the first surface is referred to as an upper surface and the second surface is referred to as a lower surface. The build-up layer 3 has a structure in which an electrical conductor layer 4 and a build-up insulating layer 5 are alternately layered. The electrical conductor layer 4 included in the build-up layer 3 is formed of an electrical conductor such as copper foil or copper plating, for example. The thickness of the electrical conductor layer 4 is not particularly limited and is, for example, 15 µm or greater and 30 µm or less.

As with the core insulating layer 2, the build-up insulating layer 5 included in the build-up layer 3 is not particularly limited as long as the build-up insulating layer is formed of a material having an insulating property. Examples of the material having an insulating property include resins such as an epoxy resin, a bismaleimide-triazine resin, a polyimide resin, and a polyphenylene ether resin. Two or more types of these resins may be mixed and used. When two or more build-up insulating layers 5 are present in the build-up layer 3, the respective build-up insulating layers 5 may be formed of the same resin or may be formed of different resins. The build-up insulating layer 5 included in the build-up layer 3 and the core insulating layer 2 may be formed of the same resin or may be formed of different resins.

The build-up insulating layer 5 included in the build-up layer 3 may include a reinforcing material, as with the core insulating layer 2. Examples of the reinforcing material include insulating fabric materials such as glass fiber, glass non-woven fabric, aramid non-woven fabric, aramid fiber, and polyester fiber. Two or more types of reinforcing materials may be used in combination. As with the core insulating layer 2, an inorganic insulating filler such as silica, barium sulfate, talc, clay, glass, calcium carbonate, or titanium oxide may be dispersed in the build-up insulating layer 5. Two or more types of inorganic insulating fillers may be used in combination.

The thickness of the build-up insulating layer 5 included in the build-up layer 3 is not particularly limited and is, for example, 25 µm or greater and 60 µm or less. When two or more build-up insulating layers 5 are present in the build-up layer 3, the respective build-up insulating layers 5 may have the same thickness or may have different thicknesses.

A via hole electrical conductor for electrically connecting layers is included in the build-up insulating layer 5 included in the build-up layer 3. The via hole electrical conductor is located in a via hole penetrating through upper and lower surfaces of the build-up insulating layer 5 included in the build-up layer 3. The via hole electrical conductor is formed of an electrical conductor such as metal plating, for example, copper plating. The via hole electrical conductor is connected to the electrical conductor layers 4 located on the upper and lower surfaces of the build-up insulating layer 5 included in the build-up layer 3. The via hole electrical conductor may be filled in the via hole, or may be located only on an inner wall surface of the via hole.

Solder resists 6 are located on a part of both surfaces of the wiring board 1 according to the first embodiment. The solder resist 6 is formed of, for example, an acryl-modified epoxy resin. The solder resist 6 has a function of protecting the electrical conductor layer 4 from solder adhesion when, for example, mounting an electronic component.

The core insulating layer 2 includes a first through-hole electrical conductor 21 and a second through-hole electrical conductor 22 so as to electrically connect the first and second surfaces (upper and lower surfaces) of the core insulating layer 2. The first through-hole electrical conductor 21 and the second through-hole electrical conductor 22 are located in through holes 2a and 2b penetrating through the upper and lower surfaces of the core insulating layer 2. The first through-hole electrical conductor 21 and the second through-hole electrical conductor 22 have, for example, tubular shapes in the through holes 2a and 2b, are formed of electrical conductors such as metal (for example, copper), and are connected to the electrical conductor layers 4 located on the upper and lower surfaces of the core insulating layer 2.

The first through-hole electrical conductor 21 located in the through hole 2a is located in a first region 11, for example, as illustrated in FIG. 1. The first region 11 is a region having a first occupancy rate in which a ratio of an opening area of the through hole 2a to a unit area is relatively high. The first occupancy rate can be calculated, for example, by reading the number of through holes 2a located in 1 mm² from an enlarged photograph of a surface of the core insulating layer 2 and multiplying the number by an opening area (mm²) per through hole 2a. In the first region 11, the opening area of the through hole 2a is, for example, 0.07 mm² or greater per surface 1 mm² of the core insulating layer 2.

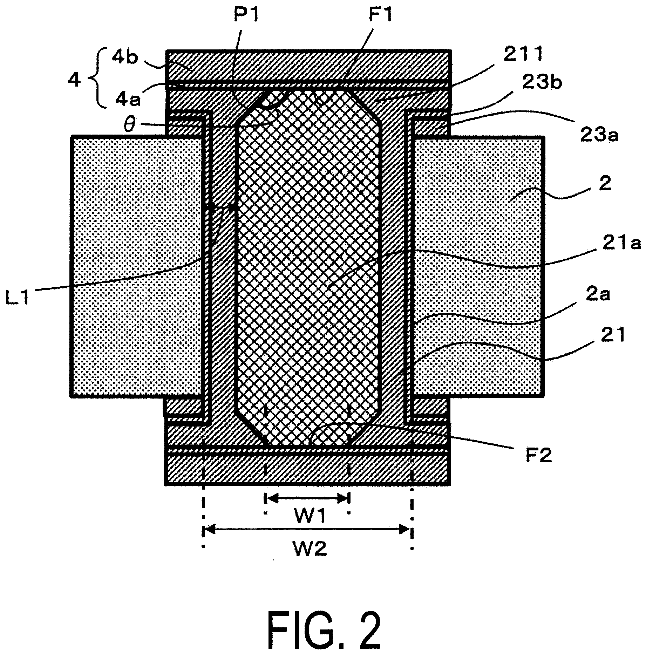

The first through-hole electrical conductor 21 is located from a periphery of the opening in the first surface of the core insulating layer 2 to a periphery of the opening in the second surface via the inner wall surface of the through hole 2a. As illustrated in FIG. 2, the first through-hole electrical conductor 21 has a protruding portion 211 extending to an inside of the through hole 2a in at least one opening of the through hole 2a. In FIG. 2, the protruding portions 211 are provided in both openings of the through hole 2a. FIG. 2 is an enlarged illustration view for illustrating a region X illustrated in FIG. 1.

The first through-hole electrical conductor 21 is not filled in the through hole 2a. In the through hole 2a, a filling resin 21a fills a portion other than the first through-hole electrical conductor 21. The filling resin 21a has a pillar shape in which a surface (end surface) located at the uppermost portion on the first surface side of the core insulating layer 2 is a first surface F1 and a surface (end surface) located at the lowermost portion on the second surface side is a second surface F2. Examples of the filling resin 21a include resins such as an epoxy resin, a bismaleimide-triazine resin, a polyimide resin, and a polyphenylene ether resin.

The width of at least one of the first surface F 1 and the second surface F2 of the filling resin 21a may be 40% or greater and 90% or less of a width of the through hole 2a. Specifically, as illustrated in FIG. 2, when the width of at least one of the first surface F1 and the second surface F2 of the filling resin 21a is denoted as W1 and the width of the through hole 2a is denoted as W2, the length of the width W1 may be 40% or greater and 90% or less of the length of the width W2. When the width of at least one of the first surface F 1 and the second surface F2 of the filling resin 21a is within such a range, it is possible to ensure the thickness of the first through-hole electrical conductor 21 in the vicinity of the opening of the through hole 2a and improve the strength, while maintaining the ease of filling of the filling resin 21a.

As illustrated in FIG. 2, when the through hole 2a is viewed in a cross section, an angle θ formed between a portion P1 of the protruding portion 211 adjacent to the filling resin 21a and the first surface F1 of the filling resin 21a is an obtuse angle. The angle θ is not limited as long as it is an obtuse angle, and may be, for example, 100° or greater and 160° or less. There are four angles θ in one cross-sectional view of the through hole 2a, and all the angles need not be the same angle. The angles θ may be different from each other as long as they are obtuse angles. The "cross section" in the cross-sectional view refers to a cross section in a depth direction of the through hole 2a (a thickness direction of the core insulating layer 2).

In the first region 11 where the through holes 2a are densely present, as illustrated in FIG. 1, via electrical conductors located in the build-up insulating layer 5 tend to be layered. By layering the via electrical conductors in this manner, stress is likely to be applied to a through-hole land located in the lower layer, and a crack is likely to occur. By the angle θ being an obtuse angle, the stress can be dispersed in the vicinity of the opening of the through hole 2a. Therefore, peeling off of the through-hole land can be reduced. Since the first through-hole electrical conductor 21 is thick in the vicinity of the opening of the through hole 2a, a crack is less likely to occur even when stress is applied. When the angle θ is 100° or greater and 160° or less, the effects can be further exhibited.

The through-hole land is a land electrical conductor that is part of the electrical conductor layer 4, and is located on the surface of the filling resin 21a located on the first surface side (the first surface F1 of the filling resin 21a), the surface of the filling resin 21a located on the second surface side (the second surfaces F2 of the filling resin 21a), and the surface of the through-hole electrical conductor (the first through-hole electrical conductor 21) located on the first and second surfaces of the core insulating layer 2.

In the core insulating layer 2, not only the first through-hole electrical conductor 21 but also the second through-hole electrical conductor 22 may be present. The second through-hole electrical conductor 22 is located in the through hole 2b of the core insulating layer 2. As illustrated in FIG. 1, the through hole 2b is located, for example, in a second region 12. The second region 12 is a region in which the ratio of the opening area of the through hole 2b to the unit area has a second occupancy rate lower than the first occupancy rate. In the second region 12, the opening area of the through hole 2b is, for example, 0.05 mm² or less per surface 1 mm² of the core insulating layer 2. The second occupancy rate can be calculated, for example, by reading the number of the through holes 2b located in 1 mm² from an enlarged photograph of a surface of the core insulating layer 2 and multiplying the number by an opening area (mm²) per through hole 2b.

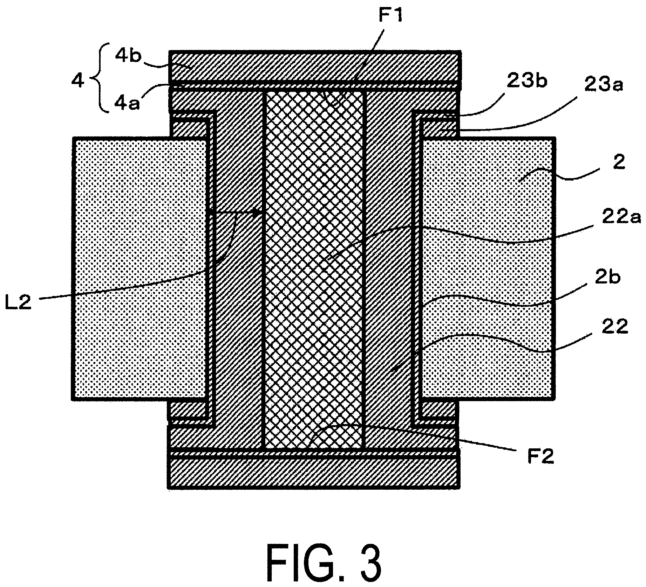

As with the first through-hole electrical conductor 21, the second through-hole electrical conductor 22 is also located from a periphery of an opening in the first surface of the core insulating layer 2 to a periphery of an opening in the second surface via the inner wall surface of the through hole 2b. As illustrated in FIG. 3, the second through-hole electrical conductor 22 does not have the protruding portion 211 that the first through-hole electrical conductor 21 has. FIG. 3 is an enlarged illustration view for illustrating a region Y illustrated in FIG. 1.

As with the first through-hole electrical conductor 21, the second through-hole electrical conductor 22 is not filled in the through hole 2b, and the remaining portion in the through hole 2b is filled with a filling resin 22a. The filling resin 22a is similar to the filling resin 21a, and detailed description thereof will be omitted.

The second through-hole electrical conductor 22 does not have the protruding portion 211. That is, widths of the surface (first surface F1) on the first surface side and the surface (second surface F2) on the second surface side of the filling resin 22a surrounded by the second through-hole electrical conductor 22 are greater than the widths of the first surface F1 and the second surface F2 of the filling resin 21a surrounded by the first through-hole electrical conductor 21 because of the absence of the protruding portions 211. In the second region 12 where the through holes 2b are sparse, as illustrated in FIG. 1, the via electrical conductors located in the build-up insulating layer 5 are less likely to be layered. For this reason, stress is less likely to be applied to the through-hole land located in the lower layer. Therefore, the filling resin 22a has a structure excellent in filling property without providing the protruding portion 211.

A thickness L2 of the second through-hole electrical conductor 22 located on the inner wall of the through hole 2b may be greater than a thickness L1 of the first through-hole electrical conductor 21 located on the inner wall of the through hole 2a. Specifically, the first through-hole electrical conductor 21 located on the inner wall of the through hole 2a may have the thickness L1 of, for example, 10 µm or greater and 40 µm or less. The second through-hole electrical conductor 22 located on the inner wall of the through hole 2b may have the thickness L2 of, for example, 10 µm or greater and 40 µm or less. Within these ranges, the thickness L2 of the second through-hole electrical conductor 22 may be greater than the thickness L 1 of the first through-hole electrical conductor 21. The thickness of the electrical conductor located on the inner wall can be, for example, an average value of values obtained by measuring the thickness of the conductor at three points in a direction perpendicular to the inner wall of the through hole.

The rigidity of the wiring board 1 can be improved by increasing the thickness of the portion of the second through-hole electrical conductor 22 located on the inner wall of the through hole 2b. As a result, bending of the wiring board 1 can be reduced. In the second region 12, the wiring tends to be longer than that in the first region 11, and the conduction resistance becomes high. By thickening the portion of the second through-hole electrical conductor 22 located on the inner wall of the through hole 2b, the conduction resistance can be reduced.

A metal layer 23a, a seed layer 23b, a seed layer 4a, and an electrolytic plating metal layer 4b illustrated in FIGs. 2 and 3 will be described together with the process of forming a region X described below.

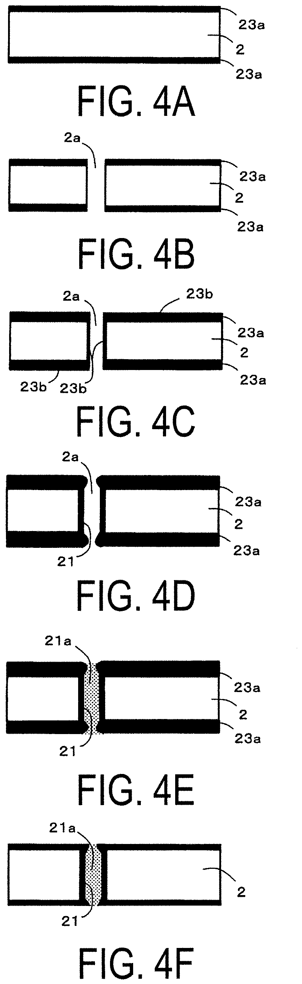

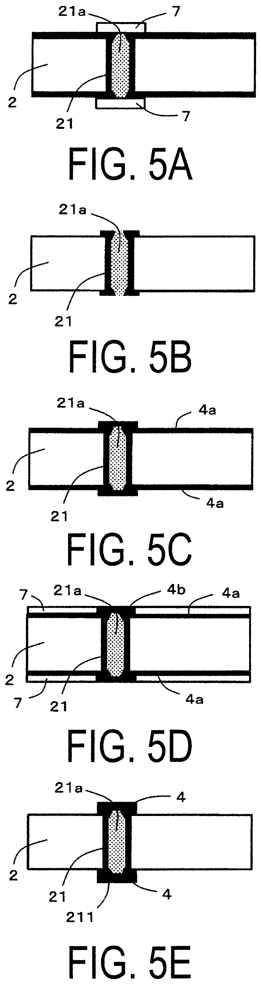

In the wiring board 1 according to an embodiment, a method of forming the first through-hole electrical conductor 21 in the through hole 2a and filling the filling resin 21a is not limited, and they are formed by, for example, a process as illustrated in FIGs. 4 and 5. FIGs. 4 and 5 are illustration views for illustrating a process for forming the region X illustrated in FIG. 1.

First, as illustrated in FIG. 4A, a double-sided metal-clad laminate plate is prepared in which metal layers 23a such as copper are layered on both surfaces of a core insulating layer 2. The thickness of the metal layer 23a is, for example, 2 µm or greater and 20 µm or less. The core insulating layer 2 is as described above, and thus detailed description thereof will be omitted.

Next, as illustrated in FIG. 4B, a through hole 2a is formed in the double-sided metal-clad laminate plate. The method of forming the through hole 2a is not particularly limited, and the through hole is formed using, for example, a drill or the like. At this time, an opening corner portion of the through hole 2a may be formed to be substantially right-angled, as with a general through hole.

After the through hole 2a is formed, a desmear treatment is performed to remove residues such as resin. After the desmear treatment, as illustrated in FIG. 4C, an electroless plating treatment is performed on an inner wall surface of the through hole 2a and a surface of the metal layer 23a to form a seed layer 23b formed of metal such as copper.

Next, as illustrated in FIG. 4D, an electrolytic plating treatment is performed to form a first through-hole electrical conductor 21 on a surface of the seed layer 23b. Since the current density is concentrated at the opening corner portion of the through hole 2a, the first through-hole electrical conductor 21 is formed thick so as to protrude to the inside of the through hole 2a. Next, as illustrated in FIG. 4E, a filling resin 21a is filled in the through hole 2a. The filling resin 21a is as described above, and thus the detailed description thereof will be omitted.

Next, as illustrated in FIG. 4F, both surfaces are polished until an angle θ formed between the corner portion (portion eventually corresponding to a protruding portion 211) where the first through-hole electrical conductor 21 is formed thick and the surface (end surface) of the filling resin 21a becomes an obtuse angle. The polishing method is not limited, and examples thereof include a buff polishing machine and a belt polishing machine.

After polishing, as illustrated in FIG. 5A, a resist 7 is formed on a portion where a through-hole land is to be formed. As the resist 7, for example, a dry film resist is used. Next, as illustrated in FIG. 5B, etching is performed to remove the metal layer 23a not covered with the resist 7, and then the resist 7 is removed.

After the metal layer 23a and the resist 7 are removed, as illustrated in FIG. 5C, an electroless plating treatment is performed on the exposed surface of the core insulating layer 2 to form a seed layer 4a of metal such as copper. The seed layer 4a is also formed on the portion covered with the resist 7. The seed layer 4a is similar to the above-described seed layer 23b.

Next, as illustrated in FIG. 5D, a resist 7 is formed on a portion other than a portion where a through-hole land is to be formed. After the resist 7 is formed, an electrolytic plating treatment is performed to form an electrolytic plating metal layer 4b of metal such as copper. Next, as illustrated in FIG. 5E, etching is performed to remove the resist 7 and the seed layer 4a covered with the resist 7, thereby forming a through-hole land (electrical conductor layer 4).

By the above process, the region X illustrated in FIG. 1 is formed. The region Y illustrated in FIG. 1 is also formed by a procedure basically similar to the above-described process. Specifically, the second through-hole electrical conductor 22, which is formed thick at the opening corner portion of the through hole 2b where the current density is concentrated, may be removed by, for example, polishing or the like, or plating conditions may be adjusted so that the second through-hole electrical conductor 22 is not formed thick, thereby filling the filling resin 22a.

The wiring board according to the present disclosure is not limited to the wiring board 1 according to the above-described embodiment. In the wiring board 1 according to the above-described embodiment, the first through-hole electrical conductor 21 is located in the first region 11, and the second through-hole electrical conductor 22 is located in the second region 12. However, in the wiring board of the present disclosure, the second through-hole electrical conductor need not be present, and the first through-hole electrical conductor may be located in the second region. The first through-hole electrical conductor and the second through-hole electrical conductor may be mixed in the first region and the second region.

### REFERENCE SIGNS

1 Wiring board
11 First region
12 Second region
2 Core insulating layer
2a, 2b Through hole
21 First through-hole electrical conductor
211 Protruding portion
21a Filling resin
22 Second through-hole electrical conductor
22a Filling resin
23a Metal layer
23b Seed layer
3 Build-up layer
4 Electrical conductor layer
4a Seed layer
4b Electrolytic plating metal layer
5 Build-up insulating layer
6 Solder resist
7 Resist
F1 First surface
F2 Second surface
P1 Portion of protruding portion adjacent to filling resin

## Claims

1. A wiring board comprising:
an insulating layer comprising a first surface and a second surface opposite the first surface;
a through hole having openings in the first surface and the second surface of the insulating layer;
a through-hole electrical conductor located from a periphery of the opening in the first surface to a periphery of the opening in the second surface via an inner wall surface of the through hole; and
a filling resin located in a region surrounded by the through-hole electrical conductor and comprising two surfaces that are a first surface on the first surface side and a second surface on the second surface side, wherein
the through-hole electrical conductor comprises a first through-hole electrical conductor,
the first through-hole electrical conductor comprises a protruding portion extending to an inside of the through hole in at least one opening of the through hole, and
in a cross-sectional view, an angle formed between a portion of the protruding portion adjacent to the filling resin and at least the first surface or the second surface of the filling resin is an obtuse angle.

2. The wiring board according to claim 1, wherein
a land conductor is located on a surface of the through-hole electrical conductor located on the first surface, the first surface of the filling resin located on the first surface side, a surface of the through-hole electrical conductor located on the second surface, and the second surface of the filling resin located on the second surface side.

3. The wiring board according to claim 1 or 2, wherein
the first angle is 100° or greater and 160° or less.

4. The wiring board according to any one of claims 1 to 3, wherein
a width of at least one of the first surface and the second surface of the filling resin surrounded by the first through-hole electrical conductor is 40% or greater and 90% or less of a width of the through hole.

5. The wiring board according to any one of claims 1 to 4, wherein
the insulating layer comprises a first region in which a ratio of an opening area of the through hole to a unit area is a first occupancy rate, and a second region in which the ratio of the opening area of the through hole to the unit area is a second occupancy rate,
the second occupancy rate is smaller than the first occupancy rate, and
the first through-hole electrical conductor is located in the first region.

6. The wiring board according to claim 5, wherein
the through-hole electrical conductor further comprises a second through-hole electrical conductor,
a thickness of a portion of the second through-hole electrical conductor located on an inner wall of the through hole is greater than a thickness of a portion of the first through-hole electrical conductor located on the inner wall of the through hole, and
the second through-hole electrical conductor is located in the second region.

7. The wiring board according to claim 6, wherein
widths of the first surface and the second surface of the filling resin surrounded by the second through-hole electrical conductor are greater than widths of the first surface and the second surface of the filling resin surrounded by the first through-hole electrical conductor.
